# FASCICULE DE BREVET EUROPEEN

(11) **EP 0 480 803 B1**
(45) Date de publication et mention de la délivrance du brevet: **05.08.1998**
(21) Numéro de dépôt: 91402651.3
(22) Date de dépôt: 04.10.1991
(51) Int. Cl.: H01L 21/331, H01L 21/306

(54) **Procédé de réalisation des métallisations d'électrodes d'un transistor**
Verfahren zur Herstellung der Elektrodenmetallisierung von einem Transistor
Method for making the electrode metallisation of a transistor

(30) Priorité: 09.10.1990 FR 9012442
(43) Date de publication de la demande: 15.04.1992
(73) Titulaire: THOMSON-CSF, 75008 Paris (FR)
(72) Inventeur: Delage, Sylvain, F-92045 Paris La Défense (FR); Collot, Philippe, F-92045 Paris La Défense (FR); Poisson, Marie-Antoinette, F-92045 Paris La Défense (FR)
(74) Mandataire: Guérin, Michel

(56) Documents cités:
- EP-A- 0 367 698
- US-A- 4 889 831
- IEEE MTT-S INT. MICROWAVE SYMPOSIUM DIGEST, V.2,9-11/6/1987, LAS VEGAS U.S. , pages 969-972,B. BAYRAKTAROGLU ET AL.:"AlGaAs/GaAs HETEROJUNCTION BIPOLAR TRANSISTORS WITH 4W/MM POWER DENSITY AT X-BAND" * page 970, alinéa 1 *

## Description

La présente invention concerne un procédé de réalisation des métallisations d'un transistor, dont l'isolation est obtenue par la réalisation sur les parois verticales d'un motif servant à autoaligner ces métallisations. Ce procédé s'applique aux composants verticaux pour lesquels est utilisée une métallisation par technique d'autoalignement : il permet d'éliminer les risques de courts-circuits sur les flancs du motif vertical.

On appelle généralement composants verticaux ceux dans lesquels le courant est transporté perpendiculairement à la surface du substrat et qui comportent un empilement de couches de matériaux semiconducteurs, dont au moins une couche superficielle est gravée en "mésa", c'est-à-dire forme un motif en relief, généralement porteur d'une métallisation d'électrode. Ainsi, les transistors bipolaires à hétérojonction, dits HBT, sont des composants verticaux : l'émetteur, la base et le collecteur sont sur trois niveaux différents. Certains transistors à effet de champ, bien que le courant s'écoule parallèlement à la surface du substrat, par exemple les SISFETS (semiconducteur - isolation - semiconducteur) peuvent être également considérés au titre de l'invention comme des composants verticaux, dans la mesure où ils comportent un motif mésa gravé qui sert à autoaligner deux types de métallisations.

Ces composants verticaux comportent des structures dites "double mésa", pour lesquelles la technologie nécessite au moins deux gravures permettant de découvrir la base et de délimiter les collecteurs, si l'on parle d'un transistor bipolaire, ou bien la grille et la source/drain, si l'on parle d'un transistor à effet de champ. Pour simplifier l'exposé de l'invention, on la présentera en s'appuyant sur l'exemple d'un transistor bipolaire.

Une des limitations de ce type de composants provient des résistances d'accès de la base, ainsi que des capacités base-collecteur dans le cas d'un HBT. La solution la plus efficace pour réduire ces parasites est de procéder à l'autoalignement de la base vis-à-vis de l'émetteur.

La difficulté des procédés d'autoalignement provient du risque de court-circuit des contacts métalliques émetteur-base. En effet, il est courant que ce soit le mésa de l'émetteur qui servira de masque d'autoalignement pour la métallisation de base : lorsque le métal est évaporé, le risque est réel que des traces métalliques sur les flancs du mésa n'entraînent un court-circuit émetteur-base. Pour éviter ces courts-circuits, différentes techniques sont couramment utilisées :
- soit le dépôt de type "side-wall" d'un isolant sur les flancs de l'émetteur, suivi d'une évaporation anisotropique de la métallisation base. Les traces métalliques sur les flancs du mésa sont ensuite éliminées par un bombardement ionique. Le procédé est par essence délicat et dépend beaucoup des systèmes d'évaporation utilisés,
- soit la couche semiconductrice d'émetteur est gravée en forme de T. Cela permet de créer un balcon qui crée un phénomène d'ombrage lors de l'évaporation du métal de base et évite ainsi les problèmes de courts-circuits. Les limitations de cette technique proviennent des incertitudes de gravure du pied de l'émetteur. La géométrie de l'émetteur n'est pas contrôlée de façon précise,
- soit la métallisation de l'émetteur est en forme de champignon. Le matériau semiconducteur est alors gravé chimiquement à partir du pied de la métallisation. Un balcon permettant l'autoalignement est ainsi créé. L'inconvénient majeur de cette technique provient du recours aux attaques chimiques qui sont parfois problématiques et manquent de précision et de fiabilité.

Le procédé d'autoalignement selon l'invention ne présente pas de difficulté à mettre en oeuvre. Ils s'appliquent aux composants utilisant des couples de matériaux III-V ou Si-SiGe. Il nécessite de disposer d'un couple de matériaux et d'un couple de méthodes de gravure tels qu'il y ait sélectivité réciproque : la méthode de gravure du premier matériau n'attaque pas le second matériau, et réciproquement. En d'autres termes, l'invention repose sur l'utilisation des sélectivité de gravure existantes pour de nombreux couples de matériaux semiconducteurs, appliquée à une structure verticale dans laquelle on a inséré une couche qui se grave facilement par rapport aux autres.

De façon plus précise, l'invention concerne un procédé de réalisation des métallisations d'électrodes d'un transistor à structure verticale, comportant les étapes suivantes :
a) formation d'une première partie d'une première métallisation d'électrode sur deux couches de matériaux semiconducteurs, ces deux couches étant constituées de matériaux réagissant de façons différentes vis-à-vis d'un couple de procédés de gravure;
b) formation d'un motif en relief par gravure de la première couche puis gravure de la deuxième couche en utilisant la métallisation comme masque de gravure, avec la formation d'une dépression par sous-gravure de la première couche;
c) formation d'une deuxième partie de la première métallisation sur la première partie et d'une deuxième métallisation sur le pied du motif en relief, la dépression assurant l'isolation entre la première et la deuxième métallisation.

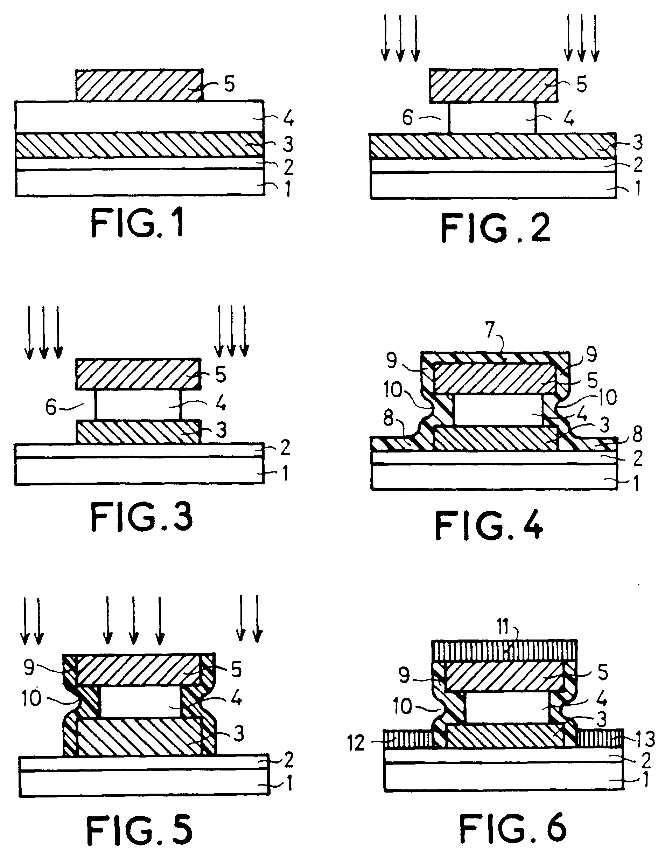

L'invention sera mieux comprise par la description qui suit maintenant d'un exemple d'application, en conjonction avec les figures 1 à 6, jointes en annexe, qui représente divers états dans le procédé de réalisation des métallisations autoalignées.

De façon encore à rendre claires les explications, le couple GaAs/GalnP est choisi en raison de ses excellentes performances, ce qui ne limite nullement la portée de l'invention : si les matériaux changent, les méthodes de gravure sélectives changent également.

Le procédé selon l'invention s'applique à partir d'une structure de transistor épitaxiée ayant déjà reçu toutes ses couches de matériaux semiconducteurs, mais dont la géométrie n'est pas achevée.

La figure 1 représente une coupe simplifiée d'une tranche de matériaux semiconducteurs épitaxiés sur un substrat, qui comprend par exemple :
- une couche 1 en GaAs N qui constituera le collecteur du transistor HBT, dont une sous-couche, sur la face libre, est dopée N+ et servira de contact collecteur,
- une couche 2 en GaAs P⁺, qui sera la base du transistor
- une couche 3 en GaInP N qui constituera l'émetteur du HBT. Il présente une sélectivité de gravure par rapport à GaAs.
- une couche 4 en GaAs N⁺ pour le contact ohmique, et qui offre une excellente sélectivité de gravure vis-à-vis du GaInP.

De façon plus générale, le procédé selon l'invention est applicable à toute structure verticale constituée de couches de matériaux présentant des sélectivités de gravure importantes, par voie sèche telle que la gravure ionique réactive, ou RIE. Le fondement de l'invention consiste à insérer dans la structure verticale un couple de matériaux dont l'un, en profondeur, sert de couche d'arrêt et dont l'autre, en surface, se grave facilement ce qui permet de réaliser un surplomb sous un masque.

Etant donné que le but recherché par ce procédé est l'autoalignement des métallisations, le masque en question est constitué par la métallisation 5 d'émetteur, en AuGe/Ni/Au, formant par alliage un excellent contact ohmique sur GaAs N^{+.}

La deuxième étape, en figure 2, est une gravure ionique réactive, symbolisée par des flèches : cette première gravure ionique décape la couche superficielle 4 de matériau semiconducteur, mais s'arrête au contact de la couche d'arrêt 3, en raison de la sélectivité de gravure. Toutefois, en prolongeant la gravure, on sous-grave en 6 la couche 4 sous le masque 5.

Pour le couple de matériaux GaAs/GaInP, la gravure ionique du GaAs par CCl₂F₂ en présence d'oxygène permet une sélectivité quasiment infinie par rapport à GaInP et une sous-gravure 6 de 200 nm de profondeur s'obtient en une minute environ.

Au cours de la troisième étape, en figure 3, la couche 3 de GaInP est gravée par une deuxième gravure ionique réactive, au moyen de CH₄ et d'hélium ou d'hydrogène. Comme la gravure par RIE est, dans son fondement, anisotropique, la couche 3 de GaInP est autoalignée sur le masque métallique 5 : la surface de l'émetteur est exactement celle du masque 5. Par ailleurs, en utilisant CH₄ et He ou H2, la sélectivité de gravure est de l'ordre de 4 entre GaInP et GaAs, ce qui signifie que l'on grave quatre fois plus vite GaInP que GaAs, ce qui permet un bon contrôle de l'arrêt de la gravure au contact de la couche 2 de la base.

Par un procédé connu, tel que la pulvérisation ou le dépôt chimique, l'ensemble de la structure est recouvert d'une couche d'isolant, tel que Si₃N₄, qui est préférable à SiO₂ avec les composés III-V tels que GaAs.

Le procédé choisi est isotrope, de sorte que le dépôt se fait également sur toutes les surfaces : en 7 sur la métallisation d'émetteur 5, en 8 sur le pourtour de la couche d'émetteur 3, et en 9 sur les flancs du mésa. La présence d'une sous-gravure 6 dans la couche 4 de GaAs entraîne en 10 une dépression dans la couche 9 d'isolant.

C'est cette dépression 10 qui, ultérieurement, après le dépôt des métallisations autoalignées, évitera les courts-circuits entre la métallisation d'émetteur et les métallisations de base, parce que le métal ne se sera pas déposé au fond de la dépression 10.

La cinquième étape du procédé selon l'invention consiste donc à éliminer les parties de cette couche isolante qui seront remplacées par des métallisations. On voit en figure 5 que la couche 7, déposée sur la métallisation 5, et la couche 8, déposée sur la couche de base 2, autour de l'émetteur 3 en GaInP, sont supprimées : elles ont été éliminées par une troisième gravure ionique réactive au moyen de SF₆. Cette gravure est anisotropique et laisse les flancs du motif en relief recouverts d'isolant, en 9.

Enfin, en figure 6, le contact de base est déposé par évaporation de métal Ti/Pt/Au par exemple. La couche 11 se dépose sur le contact métallique 5 de l'émetteur. Les couches 12 + 13 se déposent sur la couche de base 2 et s'autoalignent par rapport aux couches 5,4 et 3. La distance séparant 12 et 13 du pied du mesa 3 peut être aussi courte que 50 nm.

Au cours de cette opération de métallisation, il est courant que des particules métalliques se déposent sur les flancs du mésa, c'est-à-dire sur la couche d'isolant 9. Mais le procédé d'évaporation utilisé est sensiblement directionnel, et le métal ne se dépose pas au fond de la dépression 10. Ainsi, même si des particules métalliques sont déposées sur la couche d'isolant 9, il y a rupture au niveau du sillon 10, ce qui évite les fuites ou courts-circuits entre émetteur et base.

L'invention a été exposée en s'appuyant sur l'exemple d'un transistor vertical de type HBT, mais l'homme de l'art verra aisément qu'elle s'applique à tout dispositif comportant au moins une couche en mésa (3), sur laquelle on peut sans inconvénient ajouter une couche (4) qui se grave facilement, ceci dans le but d'autoaligner des métallisations. Ainsi, l'homme de l'art peut facilement identifier dans la figure G un transistor à effet de champ, dont les électrodes de source, grille et drain sont respectivement les métallisations 12, 11 et 13, et dont la couche active ou canal est en 2.

Les avantages du procédé selon l'invention sont les suivants - énoncés d'après l'exemple d'application :
- gravure d'une dépression contrôlée par des attaques de type R.I.E., c'est-à-dire reproductibles,
- passivation automatique des flancs de l'émetteur,
- géométrie du pied de l'émetteur connue,
- absence d'étape du type "bombardement ionique" qui a de fortes chances de compromettre les performances des dispositifs,
- limitation des courants de surface à la jonction base-émetteur. Le pied de l'émetteur et l'espacement entre celui-ci et le contact ohmique de base sont passivés.

Il est évident que l'invention s'applique aussi bien aux dispositifs en matériaux III-V, II-VI qu'à ceux en silicium en silicium-Germanium, ou en carbure de Silicium ou en diamant. Elle est seulement limitée par la nécessité de disposer de deux matériaux semiconducteurs et de deux procédés de gravure tels que la gravure d'un premier matériau soit sélective par rapport au second et réciproquement.

## Revendications

1. Procédé de réalisation des métallisations d'électrodes d'un transistor à structure verticale, comportant les étapes suivantes :
a) formation d'une première (5) partie d'une première métallisation d'électrode sur deux couches de matériaux semiconducteurs (3,4), ces deux couches étant constituées de matériaux réagissant de façons différentes vis-à-vis d'un couple de procédés de gravure;
b) formation d'un motif en relief par gravure de la première couche (4) puis gravure de la deuxième couche (3) en utilisant la métallisation (5) comme masque de gravure, avec la formation d'une dépression (10) par sous-gravure de la première couche;
c) formation d'une deuxième partie (11) de la première métallisation sur la première partie (5) et d'une deuxième métallisation (12,13) sur le pied du motif en relief, la dépression (10) assurant l'isolation entre la première et la deuxième métallisation.

2. Procédé selon la revendication 1, caractérisé en ce que l'étape b comporte les étapes suivantes :
- première gravure ionique réactive, pour graver la première couche (4) avec sous-gravure sous la première partie de la première métallisation formant masque de gravure,
- deuxième gravure ionique réactive, pour graver la deuxième couche (3) autoalignée par la première partie de la première métallisation formant masque.

3. Procédé selon l'une des revendications 1 et 2, caractérisé en ce que, après les gravures on dépose par un procédé de dépôt non directif une couche d'isolant (7, 8, 9) sur le motif en relief formé par les couches semiconductrices (3, 4) et la première partie de la première métallisation, l'isolant présentant un retrait au niveau de la première couche (4) du fait de la dépression (10), puis on élimine, par gravure anisotropique, les couches d'isolant déposées sur la première partie de la première métallisation et au pied du motif en relief, en laissant subsister de l'isolant sur les flancs du motif en relief, avant de déposer, par un procédé directif, la deuxième partie de la première métallisation et la deuxième métallisation.

4. Procédé selon la revendication 3, caractérisé en ce que la gravure anisotropique servant à éliminer l'isolant est une gravure ionique réactive à l'hexafluorure de soufre.

5. Procédé selon l'une des revendications 1 à 4, caractérisé en ce que le matériau semiconducteur de la première couche (4) est GaAs et celui de la deuxième couche (3) est GalnP.

6. Procédé selon la revendication 1, caractérisé en ce que le matériau semiconducteur de la première couche (4) est GaAs et celui de la deuxième couche (3) est GalnP, et l'étape b comporte les étapes suivantes :
- première gravure ionique réactive à l'aide de composés chlorés en présence d'oxygène, pour graver la première couche (4) avec sous-gravure sous la première partie de la première métallisation formant masque de gravure,
- deuxième gravure ionique réactive à l'aide de méthane en présence d'hydrogène ou d'hélium, pour graver la deuxième couche (3) autoalignée par la première partie de la première métallisation formant masque.

## Patentansprüche

1. Verfahren zur Herstellung von Elektrodenmetallisierungen eines Transistors mit vertikaler Struktur, das die folgenden Schritte umfaßt:
a) Bildung eines ersten Teils (5) einer ersten Elektrodenmetallisierung auf zwei Schichten (3, 4) aus Halbleitermaterialien, wobei diese beiden Schichten aus Materialien bestehen, die auf zwei Ätzverfahren unterschiedlich reagieren;
b) Bildung eines erhabenen Musters durch Ätzen der ersten Schicht (4), dann Ätzen der zweiten Schicht (3), indem die Metallisierung (5) als Ätzmaske verwendet wird, wobei durch Unterätzen der ersten Schicht eine Vertiefung (10) gebildet wird;
c) Bildung eines zweiten Teils (11) der ersten Metallisierung auf dem ersten Teil (5) und einer zweiten Metallisierung (12, 13) an dem Fuß des erhabenen Musters, wobei die Vertiefung (10) die Isolierung zwischen der ersten und der zweiten Metallisierung gewährleistet.

2. Verfahren nach Anspruch 1, dadurch gekennzeichnet, daß der Schritt b die folgenden Schritte umfaßt:
- ein erstes reaktives Ionenätzen, um die erste Schicht (4) mit Unterätzung unter dem ersten Teil der ersten Metallisierung zu ätzen, die eine Ätzmaske bildet,
- ein zweites reaktives Ionenätzen, um die zweite Schicht (3) zu ätzen, die durch den ersten Teil der eine Maske bildenden ersten Metallisierung automatisch ausgerichtet ist.

3. Verfahren nach einem der Ansprüche 1 und 2, dadurch gekennzeichnet, daß nach den Ätzungen durch ein nichtgerichtetes Abscheidungsverfahren eine Isolierstoffschicht (7, 8, 9) auf das durch die Halbleiterschichten (3, 4) und den ersten Teil der ersten Metallisierung gebildete erhabene Muster aufgebracht wird, wobei der Isolierstoff auf Höhe der ersten Schicht (4) wegen der Vertiefung (10) einen Rücksprung aufweist, und dann durch anisotropes Ätzen die Isolierstoffschichten beseitigt werden, die auf den ersten Teil der ersten Metallisierung und am Fuße des erhabenen Musters aufgebracht wurden, wobei an den Flanken des erhabenen Musters Isolierstoff belassen wird, ehe durch ein gerichtetes Verfahren der zweite Teil der ersten Metallisierung und die zweite Metallisierung aufgebracht werden.

4. Verfahren nach Anspruch 3, dadurch gekennzeichnet, daß das anisotrope Ätzen, das zur Beseitigung des Isolierstoffs dient, ein reaktives Ionenätzen mit Schwefelhexafluorid ist.

5. Verfahren nach einem der Ansprüche 1 bis 4, dadurch gekennzeichnet, daß das Halbleitermaterial der ersten Schicht (4) GaAs und dasjenige der zweiten Schicht (3) GaInP ist.

6. Verfahren nach Anspruch 1, dadurch gekennzeichnet, daß das Halbleitermaterial der ersten Schicht (4) GaAs und dasjenige der zweiten Schicht (3) GaInP ist, und daß der Schritt b die folgenden Schritte umfaßt:
- ein erstes reaktives Ionenätzen mit Hilfe von chlorierten Verbindungen in Gegenwart von Sauerstoff, um die erste Schicht (4) mit Unterätzung unter dem ersten Teil der ersten Metallisierung zu ätzen, die eine Ätzmaske bildet,
- ein zweites reaktives Ionenätzen mit Hilfe von Methan in Gegenwart von Wasserstoff oder Helium, um die zweite Schicht (3) zu ätzen, die durch den ersten Teil der eine Maske bildenden ersten Metallisierung automatisch ausgerichtet ist.

## Claims

1. Process for producing the electrode metallizations of a vertical-structure transistor, consisting of the following steps:
a) the formation of a first part (5) of a first electrode metallization on two layers (3, 4) of semiconductor materials, these two layers consisting of materials which react in different ways with respect to a pair of etching processes;
b) the formation of a raised feature by etching of the first layer (4) and then etching of the second layer (3) using the metallization (5) as an etching mask, with the formation of an indentation (10) by undercutting of the first layer;
c) the formation of a second part (11) of the first metallization on the first part (5) and of a second metallization (12, 13) at the foot of the raised feature, the indentation (10) ensuring isolation between the first and second metallizations.

2. Process according to Claim 1, characterized in that step b consists of the following steps:
- first reactive ion etching, in order to etch the first layer (4) with undercutting under the first part of the etching-mask-forming first metallization,
- second reactive ion etching, in order to etch the second layer (3) which is self-aligned by the first part of the mask-forming first metallization.

3. Process according to either of Claims 1 and 2, characterized in that, after the etching operations, an insulator layer (7, 8, 9) is deposited, using a non-directional deposition process, on the raised feature formed by the semiconductor layers (3, 4) and the first part of the first metallization, the insulator having a recess in the first layer (4) because of the indentation (10), and then the insulation layers deposited on the first part of the first metallization and at the foot of the raised feature are removed, by anisotropic etching, leaving some insulator on the side walls of the raised feature, before depositing, using a directional process, the second part of the first metallization and the second metallization.

4. Process according to Claim 3, characterized in that the anisotropic etching serving to remove the insulator is sulphur hexafluoride reactive ion etching.

5. Process according to one of Claims 1 to 4, characterized in that the semiconductor material of the first layer (4) is GaAs and that of the second layer (3) is GaInP.

6. Process according to Claim 1, characterized in that the semiconductor material of the first layer (4) is GaAs and that of the second layer (3) is GaInP and step b consists of the following steps:
- first reactive ion etching with the aid of chlorinated compounds in the presence of oxygen, in order to etch the first layer (4) with undercutting under the first part of the etching-mask-forming first metallization,
- second reactive ion etching with the aid of methane in the presence of hydrogen or of helium, in order to etch the second layer (3) which is self-aligned by the first part of the mask-forming first metallization.
